(19) Europäisches Patentamt
European Patent Office
Office européen des brevets

(11) **EP 3 586 352 B1**

(12) **EUROPEAN PATENT SPECIFICATION**

(45) Date of publication and mention
of the grant of the patent:
**07.04.2021 Bulletin 2021/14**

(21) Application number: **17706728.7**

(22) Date of filing: **21.02.2017**

(51) Int Cl.:
***H01J 37/32*** (2006.01)          ***A61B 5/08*** (2006.01)
***H01J 49/00*** (2006.01)

(86) International application number:
**PCT/EP2017/053899**

(87) International publication number:
**WO 2018/153430 (30.08.2018 Gazette 2018/35)**

(54) **METHOD FOR REAL-TIME MONITORING OF A PROCESS AND MASS SPECTROMETER**

VERFAHREN ZUR ECHTZEITÜBERWACHUNG EINES PROZESS UND MASSENSPEKTROMETER

MÉTHODE DE SUIVI D'UN PROCÉDÉ EN TEMPS RÉEL ET SPECTROMÈTRE DE MASSE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**01.01.2020 Bulletin 2020/01**

(73) Proprietor: **Leybold GmbH
50968 Köln (DE)**

(72) Inventors:
 • **CHUNG, Hin Yiu Anthony
   89075 Ulm (DE)**
 • **LUNDQUIST, Theodore
   Milpitas
   CA 95036 (US)**
 • **ALIMAN, Michel
   73447 Oberkochen (DE)**
 • **ANTONI, Martin
   73431 Aalen (DE)**
 • **FEDOSENKO, Gennady
   73433 Aalen (DE)**
 • **DERPMANN, Valerie
   73431 Aalen (DE)**
 • **REUTER, Rüdiger
   73430 Aalen (DE)**

 • **LAUE, Alexander
   89522 Heidenheim (DE)**
 • **GORKHOVER, Leonid
   89075 Ulm (DE)**
 • **GORUS, Andreas
   73457 Essingen (DE)**

(74) Representative: **Norton, Ian Andrew
   Edwards Limited
   Innovation Drive
   Burgess Hill
   West Sussex RH15 9TW (GB)**

(56) References cited:
   WO-A2-2014/117747      US-A1- 2007 224 840
   US-A1- 2008 075 834      US-B1- 7 003 366

 • CHUNG HIN YIU ET AL: "Very sensitive real-time
   inline process mass spectrometer based on FFT
   Ion Trap technique", 2016 27TH ANNUAL SEMI
   ADVANCED SEMICONDUCTOR
   MANUFACTURING CONFERENCE (ASMC), IEEE,
   16 May 2016 (2016-05-16), pages 263-266,
   XP032912526, DOI: 10.1109/ASMC.2016.7491140
   [retrieved on 2016-06-13]

## Description

Technical Field

The invention relates to a method for real-time monitoring of a process and to a mass spectrometer.

Background of the Invention

State of the art semiconductor manufacturing, chemicals or chemical gas production, surgery, environmental monitoring etc. consist of a series or a train of sophisticated jobs (processes). These processes have to be closely monitored job by job or process step by process step.

In the case of semiconductor manufacturing, processes such as epitaxy, Chemical Vapor Deposition (CVD), dry etch (with and without plasma), Atomic Layer Deposition (ALD), Physical Vapor Deposition (PVD), sputtering, Molecular Beam Epitaxy (MBE), etc. involve chemistries, products of which are deposited, etched and doped in a controlled gas/plasma chamber system. Some of these processes are not monitored at all (e.g., processing of wafers with good luck), while others of these processes are vigorously controlled by monitoring all possible process parameters (chamber humidity, temperature, plasma power, chemistry flows, pumping efficiencies, flow constrictions, gas injectors, etc.). Dynamically tracking these process parameters provides a fingerprint of each process, which can help with tool matching, see e.g. "A Novel Technique for Epitaxy Tool-to-Tool and Chamber Matching and Optimization", R.G. Cosway et al., 27th Annual SEMI Advanced Semiconductor Manufacturing Conference (ASMC) 2016, IEEE proceedings, pp. 429-434.

Modern semiconductor devices (novel transistors-structures, memory cells, diodes, passive devices, laser diodes, LEDs) consist of vertical multilayer structures. As the layers vertically become thinner, the process time is decreased (if process time is not decreased then the contribution of background species can be more detrimental). Furthermore, the composition of the process gases is becoming more and more complex (past: Si, Si-related compounds and dopants. Today: well established (i.e. Si, Si- related compounds and dopants) + metalorganics, various combinations of monomers, chlorides, fluorides, etc.). For this reason, if monitoring methods are used, these existing monitoring methods which might have provided benefit previously (optical emission spectroscopy (OES), reflectometry) have now become obsolete due to the lack of real time capable speed, sensitivity and robustness against aggressive process environment, due to the measuring of only a fixed and limited type of species, and very often also due to the off-line post process nature of the measurement, which are used for the determination of failure or success of the process. A corollary problem to process monitoring is also checking for wafer and chamber health before initiating and after completing a process. The same situation exists also in the chemicals, chemical gas production, for advanced surgery or environmental monitoring.

Moreover, for the most part of these manufacturing or production processes, the outcome is determined only after the process is completed by metrology tools and methods. For instance, at the 10 nm or 7 nm node, 70% of wafer routing is expected to be to the post process metrology tools, see "Reducing Metrology Mean-Time-To-Detect by Utilizing Product Data", D. Crauder et al., ASMC 2016, IEEE proceedings, pp. 423-428, 2016.

In the case of medicine, surgeons need to identify undesired or unexpected variations in the tissues in real time during an operation. Today, tissue samples are collected during the operation and shipped to the histology for ex-situ investigation. During the investigation, the surgeon and the patient have to wait in the operation theatre where the patient is exposed to the risk of infection and unnecessary prolongation of physical stress. Furthermore, ex-situ investigations always bear a certain risk of alteration or contamination of the tissue samples during transportation. Therefore, determining the nature or the outgassing of the tissues or the expiration of the patient early-on and a correlation between the outgassing of the tissues and the histology for sharpening the real-time monitoring are needed. In a similar way, ear, nose & throat doctors need to identify undesired or unexpected variations in the expiration of a patient in real time during diagnostic.

In general, the disadvantages of the existing methods for process monitoring are that these are too slow and/or too insensitive and/or that these are not able to do a broadband measurement for detecting all process related species at one time AND at the same time capable to selectively focus on and trace some particular species selectively which are critical during the process evaluation, non-robustness against the aggressive process environment, a large footprint, etc.

In view of the above, technologies have to be developed which, in the case of semiconductor manufacturing, can dynamically provide an analysis (fast and sensitive) of the process chemistries that are utilized in the process chamber. These technologies have to provide the ratio of particular process critical species that are important to the outcome of the process and thus these process critical species can be tracked during the process as well as species that are detrimental to the process. Undesired variations in the evolution of these processes can be detrimental to the outcome, costing time and resources. Moreover, technologies have to be developed for real-time environmental monitoring, monitoring of tissue outgassing, monitoring of the expiration of a patient, etc.

WO 2013/104583 A2 discloses a method for monitoring surface processing on a substrate, comprising: carrying out a residual gas analysis for detecting at least one gaseous constituent of a residual gas atmosphere formed in an interior of a chamber for arranging the substrate. The gaseous constituent to be detected is ionized by means of an ionization device; the ions of interest are stored for carrying out the residual gas analysis in an ion trap, in particular in an FT ion cyclotron resonance trap (FT-ICR trap). The use of such ion trap technics, in particular an FT ion trap, is a very versatile analysis-method which makes it possible to carry out a "real-time measurement" or a "real-time detection" of the gaseous constituent, i.e. a measurement in a few seconds or milliseconds. A mass spectrometer using a FT-ICR trap is also known from WO 2015/003819 A1.

WO 2016/177503 A1 discloses a method and a mass spectrometer for examining a gas by mass spectrometry, comprising: ionizing the gas for producing ions, and storing, exciting and detecting at least some of the produced ions in an FT ion trap. In the method, producing and storing the ions in the FT ion trap and/or exciting the ions prior to the detection of the ions in the FT ion trap comprises at least one selective IFT excitation, in particular a SWIFT("Storage Wave-Form Inverse Fourier Transform") excitation, which is dependent on the mass-to-charge ratio of the ions. "Very sensitive real-time inline process mass spectrometer based on FFT Ion Trap technique",Chung Hin Yu et al., 27th annual SEMI Advanced Semiconductor manufacturing Conference(ASMC), 2016, IEEE Proceedings, pp. 263-266, discloses a new, very fast and extremely sensitive inline process mass spectrometry technique based on Fourier-Transform 3D-Quadrupole Ion Trap technology. The technology is capable to detect reaction products, contaminations on the wafer holder and dopant memory effects in real-time. US-A1-2007/224840 discloses a method of selecting plasma doping process parameters, which includes determining a recipe parameter database for achieving at least one plasma doping condition. In-situ measurements of at least one plasma doping condition are performed. The in-situ measurements of the at least one plasma doping condition are correlated to at least one plasma doping result. At least one recipe parameter is changed in response to the correlation so as to improve at least one plasma doping process performance metric.

Object of the invention

It is an object of the invention to provide a method for real-time process monitoring and a mass spectrometer adapted to perform the method which overcome at least one of the disadvantages of the methods set forth above.

Summary of the Invention

One aspect of the invention relates to a method for real-time monitoring of a surface processing of an object, as defined in claim 1, comprising: performing a mass spectrometric real-time measurement of a gas mixture generated in the monitored process to determine real-time mass spectrometric data indicative of the monitored process, evaluating the monitored process by correlating and/or calibrating the real-time mass spectrometric data with metrology data determined by at least one post-process metrology method for evaluating a previous process.

In the above-described monitoring method, real-time monitoring of the process, i.e. monitoring in the millisecond-range, is performed by a fast mass spectrometric measurement of a gas mixture that is generated during the process. Undesired deviations from a normal process, may be determined in real-time when the real-time mass spectrometric data is correlated and/or calibrated with metrology data determined by at least one post-process metrology method. In the case of the calibration, the previous process is typically a standard (successful) process. In this way, the process, resp., the process monitoring, can be matched on multiple processing systems.

The real-time mass spectrometric data provided in the mass-spectrometric measurement may include at least one mass spectrum of the gas mixture which is taken during each of a plurality of subsequent process-steps (in real-time). For real-time monitoring of the outgassing of an object such as a wafer, the real-time mass spectrometric data may also include or consist of a plurality of mass spectra of the gas mixture which are taken in real-time. The real-time mass spectrometric data provided in the mass-spectrometric measurement may also include at least one selected mass signal (specific mass-to-charge-ratio signal) of a mass spectrum of the gas mixture which is taken during each of a plurality of process steps, from the outgassing of an object such as a wafer. Based on the real-time mass spectrometric data, a time trend of the evolution of at least one specific mass signal may also be determined.

The real-time mass spectrometric data is indicative of the monitored process, i.e. the mass spectrometric data typically contains information about at least one species / constituent of the gas mixture which is critical / important for the outcome of the process. The real-time mass spectrometric data may in particular be indicative of a future evolution of the monitored process (see below).

In one variant, the monitored process is selected from the group consisting of: surface processing of an object, e.g. a substrate, in particular of a wafer. In the case of semiconductor manufacturing, the surface processing may be e.g. atomic layer deposition (ALD), Atomic Layer Etching (ALE), chemical vapor deposition (CVD), dry etch (with or without plasma), epitaxy (Epi), molecular beam epitaxy (MBE), physical vapor deposition (PVD), etc. In the case of semiconductor manufacturing, the gas mixture may be provided in a processing chamber where the surface processing takes place. In the case of surface processing, the gas mixture may comprise gaseous constituents in the form of precursors or dopants such as SiH4, $Cl_2$, $AsH_4$, $PH_4$, $B_2H_6$, as well as

gaseous constituents outgassing from the processed object, e.g. from a wafer. Using the real-time mass spectrometric data, changes of plasma photoemissions during plasma-etching, changes of the absorption of ambient gases, changes of the concentration of extrinsic gases etc. may be determined and the process may be evaluated accordingly.

In the case of chemical gas production, not forming part of the invention, the gas mixture may be in a process reactor where the chemical gas production takes place, the gas mixture typically comprising precursors and/or contaminations. In environmental monitoring, not forming part of the invention, the outgassing object may be an emission source such as a motor, and the gaseous mixture may comprise process exhaust air, for instance air and contaminants such as $CO_2$, aromatic compounds, $CO$, $NO_2$, etc. In all of these cases, changes of the overall content of the gas mixture, of specific constituents of the gas mixture, or changes of the behaviour of the object which depend on the composition of the gas mixture may be determined and a time evolution or a time trend of the evolution of the monitored process may be obtained.

The mass-spectrometric real-time measurement of the gas mixture generated in the monitored process is preferably performed in a mass spectrometer comprising an FT ion trap, in particular in an electrical FT ion cyclotron resonance trap (FT-ICR trap). When the monitored process includes surface processing, for instance surface processing of a substrate for semiconductor manufacturing, the gas mixture is typically provided to the mass spectrometer from a processing chamber where the substrate is arranged. When the process includes or consists of monitoring outgassing from an object, e.g. from a wafer, the mass spectrometer may be connected to a storage box for storing the object.

A supply line, e.g. a hose, may be used for connecting the mass spectrometer to the process chamber, storage box, to introduce the gas mixture into the mass spectrometer. The gas mixture, e.g. comprising process gas or gas outgassing from the object may be introduced into the mass spectrometer through a gas inlet valve at the end of the supply line / hose. The gas mixture is typically introduced into the mass spectrometer in an electrically neutral state and the mass spectrometer comprises at least one ionization unit for generating ions of at least part of the gas mixture, i.e. for ionizing at least part of the neutral gas. The ionization unit may comprise an electron gun (e.g. 70 eV, or another suitable ionization-energy) for electron beam ionization of the neutral gas. Alternatively, the gas mixture may be analysed outside the ion trap.

The storage, excitation and detection of at least part of the generated ions is preferably performed in the FT-ion trap. As indicated above, the ions may be generated in the FT-ion trap, e.g. by electron beam ionization. The ions may be stored in the FT-ion trap by means of radio frequencies. The ions may be electrically excited and detected by means of a non-destructive method, in particular by means of the Fourier-Transformation of the ion mirror current on the cap electrodes of the FT-ion trap. Previous to the ion detection, the ions may be at least once selectively excited according to their corresponding mass-to-charge ratio, in particular, by means of a SWIFT excitation.

In one variant, the method further comprises: based on the evaluation, performing a decision to either proceed with or to stop the monitored process. If the mass spectrometric data changes / deviates more than expected from a standard process, the above-described monitoring method allows to alert the operator immediately, so that a fast decision (real-time decision) can be made to either proceed with or to stop the monitored process. The decision-making may be an automated process. Alternatively, the real-time monitoring may aid an operator in making a decision by indicating the degree of the deviation of the monitored process from a standard process. In all these cases, real-time decision-making (Go/No Go; Carry on processing / Stop processing) is performed.

In another variant, the method further comprises: based on the evaluation, changing at least one process parameter of the monitored process in real-time. In particular, the at least one process parameter may be changed in such a way that the monitored process approaches the (successful) previous process as closely as possible, resp., that the monitored process no longer deviates from the process window.

In yet another variant, the method further comprises: based on the evaluation, predicting an outcome of the monitored process and/or an outcome of at least one post-process metrology method used for evaluating the monitored process. In this variant, the outcome / result of the process (e.g. the result of surface processing of a substrate such as a wafer, at least one property of a product which is manufactured during a production process, etc.) and/or the outcome of at least one post-process metrology method is predicted in real-time early on, i.e. before the process is completed. In this way, process variations can be controlled in a better way and a decision can be made immediately if failure occurs. Moreover, predictive metrology may be performed which - in the case of a wafer - should be able to reduce wafer processing time.

In one variant, the at least one post-process metrology method for evaluating the (previous) process is a post-process metrology method for inspecting an object that is processed or produced in the previous process. In this variant, the correlation and/or calibration of the real-time mass spectrometric data is made by evaluating the outcome of the previous process in the form of the object that is processed or produced in the previous process. The calibration with the post-process metrology method allows to define a standard for all upcoming real-time measurements of the same processes. In particular, the metrology data determined by the at least one post-process metrology method may be mass-spectrometric data. In this case, a direct comparison between the real-time mass spectrometric data and the metrology data may be made.

In the semiconductor manufacturing case, the correlation or calibration may be carried out as follows: By providing mass spectra (fingerprint spectra) determined by a post-process metrology method indicative of a successful process, comparisons can readily be made during the monitored process both on its evolution and to previous successful processes. Typically, at least one fingerprint spectrum is provided for each process step of the monitored process. In particular, a plurality / a sequence of fingerprint spectra may be provided for each process step, each fingerprint spectrum being taken at a different point in time, so that the sequence of fingerprint spectra is indicative of a time evolution of the process step. These spectra can readily be used to compare to those of a similar process running in another process chamber for which both process chambers should have the same fingerprint spectra and evolution.

The "golden" (i.e. optimum) fingerprint mass spectra evolution can also be utilized to flag a monitored process as it drifts, i.e. deviates from a standardized process for which the fingerprint spectra are indicative (see above), so that the monitored process can be brought back before the drift becomes excessive.

A fingerprint spectrum of the gas mixture outgassing from a healthy wafer or provided in a healthy process chamber can determine the health or lack thereof for other wafers or processing chambers, respectively. Research has shown that wafers that experienced longer times between process steps had higher yield losses, see for instance "Yield Improvement and Queue Time Relaxation at Contact Process", Niti Garg et al., ASMC 2016, IEEE proceedings, pp. 344-349, 2016.

As indicated above, the result / outcome of the monitored process can also be predicted from the golden mass fingerprint spectra of the monitored process. Moreover, what a process metrology tool will measure can also be determined from the mass fingerprint spectra evolution - predictive metrology which should be able to reduce wafer process time.

In a preferred variant, the (ex-situ) post-process metrology method is selected from the group consisting of: X-Ray-diffraction (the metrology data being e.g. rocking curves / Omega scan), secondary ion mass spectrometry (the metrology data being e.g. spatially resolved mass spectra), scanning electron microscopy (the metrology data being e.g. SEM-pictures of structures on the object / sample), X-ray photoelectron spectroscopy (the metrology data being e.g. chemical bond strengths of the sample surface), and ellipsometry (the metrology data being e.g. thickness, refractive index, absorption coefficient, etc. of layers applied to an object, e.g. a wafer). The post-process metrology methods described above are typically used for inspecting an object that is processed or produced in the (previous) process.

The metrology data obtained by inspecting the object that has been processed or produced in the process can be used to correlate / calibrate the real-time mass spectrometric data by evaluating the outcome of the process (in the form of an object). In particular, metrology data in the form of mass-spectrometric data of a standard process may be obtained and used for the comparison in the real-time monitoring method described above. In particular, based on the metrology data, limit values, in particular limit values of suitable process windows, may be defined, allowing to evaluate the monitored process in real-time by comparing the real-time mass spectrometric data with the limit value(s), and thus allowing fast decision making about the process and/or about the behaviour of an object that is involved in the process. In particular, different objects may be distinguished in this way.

After calibration, ellipsometry results can be correlated to a series of mass spectra, resp. to the mass-spectrometric data, taken during a surface processing of an object in real-time, for instance during a deposition process of a plurality of layers on a wafer, even if the deposition process is complicated. The ellipsometry data should provide the deposition thickness of the individual layers which would be available through the integration of the mass-spectrometric data. If the mass spectra were stable during the deposition process, then the thickness thk would be proportional to the product of the chemistry density p, the rate of deposition R and the length of the deposition time T, i.e.

$$th_k = \alpha \, \rho \, R \, T,$$

and assuming the ellipsometry model is correct these would agree ($\alpha$ is a proportional constant).

When constituents vary during the deposition then the equation for the overall thickness th gets more complicated:

$$th = \Sigma \, \alpha_i \, \rho_i \, R_i \, T_i,$$

where i indicates that each constituent group has its own proportionality constant $\alpha_i$, density $\rho_i$, rate $R_i$ and time $T_i$.

Based on a model which correlates calibrated mass-spectrometric data obtained during the deposition process with metrology data obtained by post-process ellipsometry, the unknown parameters density $\rho_i$ and rate $R_i$ of the individual layers may be determined and thus the thickness $th_i$ of each individual layer that is deposited on the object may be obtained. The thicknesses of the layers determined in this way may be used to evaluate the monitored process, more specifically the outcome of the monitored process, as the thickness of each deposited layer should lie within a process window (i.e. within a pre-defined thickness interval).

In a further variant, performing the mass spectrometric real-time measurement of the gas mixture comprises storing and analysing (e.g. exciting and detecting) ions of at least part of the gas mixture in an ion trap of an FT-Ion-Trap-Mass Spectrometer, in particular in an ion trap of an electrical FT-Ion-Trap-Mass Spectrometer.

In an improvement of this variant, the method further comprises: selectively exciting at least part of the ions in the ion trap in dependence of a mass-to-charge ratio of the ions, in particular using a SWIFT excitation. As indicated above, by performing at least one selective excitation of the ions stored in the FT ion trap, in particular by using a SWIFT excitation, minute traces of ions, in particular of ions of gaseous species which are critical for the monitored process, may be detected, by eliminating unwanted ions from the ion trap. The SWIFT excitation may be performed e.g. as described in WO 2016/177503 A1 cited in the introduction.

State of the art approaches e.g. for etch process monitoring utilize light emission to track peaks associated with major plasma chemistry processes, and when there are emission peaks associated with the critical process chemistries these techniques do well as they are fast. When the process is not a plasma process, these monitoring techniques do not work at all, and optical absorption is used, so that light transits the chemistries in the chamber multiple times to obtain sufficient signal to identify differences and thus track the process. For the most part, these techniques cannot track minor constituents which can ruin a process.

In view of the above, performing the mass spectrometric real-time measurement in an FT-Ion-Trap-Mass Spectrometer provides the following advantages:

1.) The FT-Ion-Trap-Mass Spectrometer is able to do broadband measurements for detecting all process-related species / gaseous constituents of the gas mixture at one time AND is at the same time capable to selectively focus on and trace some particular species selectively which are critical during the process evaluation.

2) The FT-Ion-Trap-Mass Spectrometer may comprise metal electrodes having surfaces plated with a wear-resistant material such as gold and is therefore less sensitive to degradation from the chemical species that are present in the process chamber than other possible solutions. In particular, the FT-Ion-Trap-Mass Spectrometer does not contain any degradable detectors.

3) The FT-Ion-Trap-Mass Spectrometer provides speed since FFT (Fast Fourier Transform) is used to create spectra out of an ion mirror current. Depending on the algorithm and the electronic implementation, the FFT process can be performed in millisecond-range.

4) The FT-Ion-Trap-Mass Spectrometer may provide high sensitivity (ppmV, ppbV, pptV or sub-pptV) by using SWIFT-technics (see above) to dynamically and simultaneously remove dominant ion species from the Ion-Trap and thus allows minute trace of ion signals coming out of the noise level without being permanently interfered by other larger ion signals originated from the carrier gas matrix or from the gas background.

All properties 1) to 4) are advantageous and are used together with the calibration of the mass spectra and/or time trends of the mass spectra of the FT-Ion-Trap with post process measurements and/or (specification) limits and the use of the calibrated results as standards for upcoming real time measurements for decision-making.

Moreover, the monitored process should be calibrated against post process metrology tools. These tools are important in identifying optimization of the critical aspects of different processes. Calibration is key to the development of an algorithm to transfer the data from the fast and sensitive FT-Ion-Trap mass spectrometer to a prediction of what the Ion-Trap will measure. (Typically, the Ion-Trap actually assumes an algorithm from what it measures to what is an important fundamental process parameter. As this step is no longer critical to production, calibration to the Ion-Trap makes the most sense.)

Each post-process metrology technique / tool provides a standard to which the mass spectra evolution must be calibrated. It may be that variations in the mass spectra evolution may produce the same predictive results for each tool. It will be key to learn what the window is for a mass analyser spectra evolution and still have an acceptable predictive result / outcome of the monitored process. Where the calibration windows for each metrology tool overlap will provide process optimization.

In a further variant, the method further comprises: obtaining further real-time data indicative of the monitored process by performing at least one further real-time measurement method, and evaluating the monitored process by correlating and/or calibrating the further real-time data with metrology data determined by at least one post-process metrology method for evaluating a previous process and/or by comparing the further real-time data with at least one limit value, preferably with a limit value of a process window of the monitored process.

In addition to the mass spectrometric real-time measurement of a gas mixture generated in the process, real-time data indicative of the process that are obtained by other real-time measurement methods may be used as well for evaluating the process. In particular, the overall evaluation of the process may be performed by combining the results of the evaluation based on the real-time mass spectrometric data and of the evaluation based on the further real-time data indicative of the monitored process.

In a preferred variant, the further real-time measurement method is selected from the group consisting of: optical emission spectroscopy, optical absorption spectroscopy, reflectometry, pyrometry, Raman scattering, scatterometry, in-situ X-Ray diffractometry (XRD), and quadrupole rest gas analyzation. The further data that is obtained by these real-time measurement methods are e.g. spectra, so-called rocking curves (Omega scan in XRD), etc.

A further aspect of the invention relates to a mass spectrometer for real-time monitoring of a surface processing of an object, as defined in claim 12, comprising: an ionization unit for generating ions of at least part of a gas mixture generated during the monitored process, an FT ion trap for storing the ions of the gas mixture, an excitation unit for exciting at least part of the ions stored in the FT ion trap, a detector for determining, based on the excited ions, real-time mass spectrometric data of the gas mixture indicative for the monitored process, and an evaluation unit adapted to evaluate the monitored process, wherein the evaluation unit is adapted to correlate and/or calibrate the real-time mass spectrometric data with metrology data determined by at least one post-process metrology method for evaluating a previous process The FT ion trap mass spectrometer provides the advantages 1) to 4) described above.

In another embodiment, the evaluation unit is adapted to predict, based on the evaluated monitored process, an outcome of the monitored process and/or an outcome of a post-process metrology method used for evaluating the monitored process. In particular, when the post-process metrology method is used for inspecting a wafer, the prediction of the evaluation unit should be able to reduce wafer processing time.

In a further embodiment, the at least one post-process metrology method for evaluating the previous process is a post-process metrology method for inspecting an object that is processed or produced in the previous process, for instance a wafer that is processed in the previous process.

Other features and advantages of the invention will be apparent from the following detailed description, and from the claims.

Brief Description of the Drawings

Exemplary embodiments, including embodiments of the invention, are shown in the diagrammatic drawing and are explained in the description below. The following are shown:

Fig. 1    a schematic illustration of an apparatus for atomic layer deposition on a wafer,

Fig. 2    a schematic illustration of a mass spectrometer with an electrical FT-Ion Trap,

Fig. 3a,b    schematic illustrations of two mass spectra obtained by secondary ion mass spectrometry of a wafer,

Fig. 4a,b    schematic illustrations of two series of mass spectra obtained by real-time measurements of a gas mixture,

Fig. 5a,b    schematic illustrations of a mass spectrometer used for monitoring outgassing from human tissue and for monitoring outgassing from the mouth of a patient,

Fig. 6a,b    schematic illustrations of real-time mass spectra of the outgassing of normal tissue and of pathological tissue,

Fig. 7    a schematic illustration of two real-time mass spectra and of a time evolution of the concentration of one constituent of a gas mixture, and

Fig. 8    a schematic illustration of a series of mass spectra taken during a deposition process and of a post-deposition ellipsometry measurement.

Detailed Description of the Invention

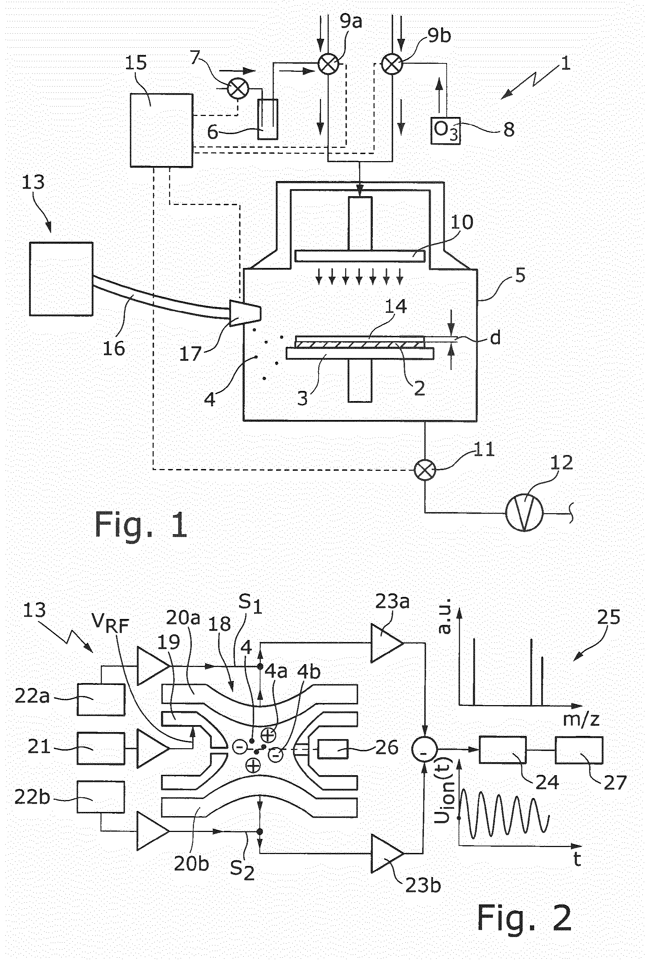

Fig. 1 schematically shows an apparatus 1 for atomic layer deposition on an object in the form of a silicon wafer 2, arranged on a holder 3 in an interior of a process chamber 5 containing a gas mixture 4. Both the holder 3 and the walls of the process chamber 5 can be heated to (if appropriate different) temperatures. The holder 3 can be connected to a motor in order to cause the substrate 2 to effect a rotational movement during coating. The apparatus 1 also comprises a container 6 containing a metallo-organic precursor material, which is Tetrakis(EthylMethylAmino)Hafnium (TEMAH) in the present example. In order to bring the precursor material from the container 6 into the process chamber 5, an inert carrier gas, e.g. argon, is used, which can be fed to the container 6 via a controllable valve 7. A further container 8 serves for providing ozone gas $O_3$ as a reactant during the atomic layer deposition.

The carrier gas with the precursor and the ozone gas can respectively be introduced into the process chamber 5 by a controllable inlet in the form of a controllable valve 9a, 9b. A distribution manifold 10 is arranged in the chamber 5 in order to distribute the incoming gas as homogeneously as possible in the direction of the substrate 2. Via the controllable valves 9a, 9b, a purging gas, e.g. argon, can also be fed to the process chamber 5 in order to purge the process chamber 5 and the respective feed lines. A further controllable valve 11, which forms a gas outlet, is connected to a vacuum pump 12 in order to remove the gases from the process chamber 5.

For applying a coating 14 composed of hafnium oxide ($HfO_2$) to the substrate 2, the following procedure is adopted: firstly, the carrier gas with the TEMAH precursor is fed to the process chamber 5 via the first valve 9a. Afterwards, the first valve 9a is switched over and the purging gas is fed to the process chamber 5 via the first valve 9a (cf. arrow) and said gas together with the residues of the carrier gas and/or of the precursor is extracted via the open exit valve 11 by means of the vacuum pump 12. After purging, the exit valve 11 is closed and ozone gas is introduced into the chamber 5 via the second valve 9b, said ozone gas entering into a chemical reaction with the precursor on the exposed surface of the substrate 2. The chamber 5 is subsequently purged by means of the purging gas, which is fed to the chamber via the second valve 9b (cf. arrow) and together with the ozone residues and/or reaction products possibly formed is extracted by means of the vacuum pump 12 with the exit valve 11 open. During the process described above, a monolayer composed of hafnium oxide is deposited on the substrate 2. After the exit valve 11 has been closed, this process can be repeated a number of times, specifically until the $HfO_2$ coating 14 has attained a desired thickness d.

The time duration for feeding the carrier gas with the precursor, the time duration for feeding the ozone gas and the time duration of the purging process are typically in the seconds range. A control device 15 serves for driving the valves 7, 9a, 9b, 11, in order to switch over between the above-described steps of the deposition process. It goes without saying that not only can the control device 15 switch over the valves 7, 9a, 9b, 11 between an open position and a closed position, but that, if appropriate, the mass flow which flows through the respective valves 7, 9a, 9b, 11 can also be controlled by means of the electronic control device 15.

For the purpose of monitoring the gas mixture 4 in the process chamber 5, a mass spectrometer 13 is connected to the process chamber 5 via a supply line 16 (a hose). The gas mixture 4, more specifically part of the gas mixture 4, is introduced into the mass spectrometer 13 through a gas inlet valve 17 at the end of the supply line 16. The control device 15 additionally serves for driving the gas inlet valve 17 which connects the mass spectrometer 13 to the process chamber 5.

For monitoring the surface processing of the wafer 2 illustrated in connection with Fig. 1, it is advantageous to determine mass spectrometric data (e.g. mass spectra) of the gas mixture 4 in real-time, i.e. in the millisecond-range. In order to achieve this, the mass spectrometer 13 comprises an electrical FT ion trap 18 which is described in more detail below in connection with **Fig. 2.**

In the electrical FT ion trap 18 of Fig. 2, the ions 4a, 4b are trapped between a ring electrode 19 and a first and second cap electrode 20a, 20b. For storing the ions 4a, 4b in the ion trap 18, an RF signal generation unit 21 generates a radio frequency signal VRF that is provided to the ring electrode 19. Two excitation units 22a, 22b each generate an excitation signal S1, S2 provided to a respective cap electrode 20a, 20b to excite the ions 4a, 4b to effect oscillations. An oscillation frequency of the ions 4a, 4b in the ion trap 18 depends on a mass-to-charge ratio of the ions 4a, 4b. Two measurement amplifiers 23a, 23b amplify a respective measurement current caused by the oscillations. An ion signal $u_{ion}(t)$ is generated from a difference between the two measurement currents. A detector 24 that comprises a FFT ("fast Fourier transform") spectrometer serves to perform a Fourier transformation of the ion signal $u_{ion}(t)$ and for determining real-time mass spectrometric data in the form of mass spectra 25. The mass spectra 25 indicate the number / concentration (in arbitrary units, a.u.) of excited ions 4a, 4b in dependence of their mass-to-charge ratio m/z. In other words, the mass spectra 25, resp., the mass-spectrometric data 25 is indicative of the mass-to-charge distribution of the ions 4a, 4b in the gas mixture 4.

In the example of Fig. 2, the gas mixture 4 is introduced into the mass spectrometer 13 in an electrically neutral state and the mass spectrometer 13 has an ionization unit 26 for generating ions 4a, 4b of at least part of the gas mixture 4 to ionize at least part of the neutral gas introduced into the mass spectrometer 13 via the supply line 16. In the present example, the ionization unit 26 comprises an electron gun (e.g. 70 eV or another suitable ionization-energy) for electron beam ionization of the neutral gas mixture 4 introduced into the ion trap 18.

Previous to the detection, the ions 4a, 4b may be at least once selectively excited according to their mass-to-charge ratio m/z, for instance, by means of a SWIFT excitation. The SWIFT excitation may in particular serve to eliminate ions 4a, 4b having specific mass-to-charge ratios from the ion trap 18. In particular, ions 4a, 4b of a buffer or background gas may be eliminated from the ion trap 18 in this way, thus allowing the detection of minute traces of ions 4a, 4b of gaseous species which are critical for the monitored process. The mass spectrometer 13 shown in Fig. 2 also comprises an evaluation unit 27, the purpose of which will be described further below.

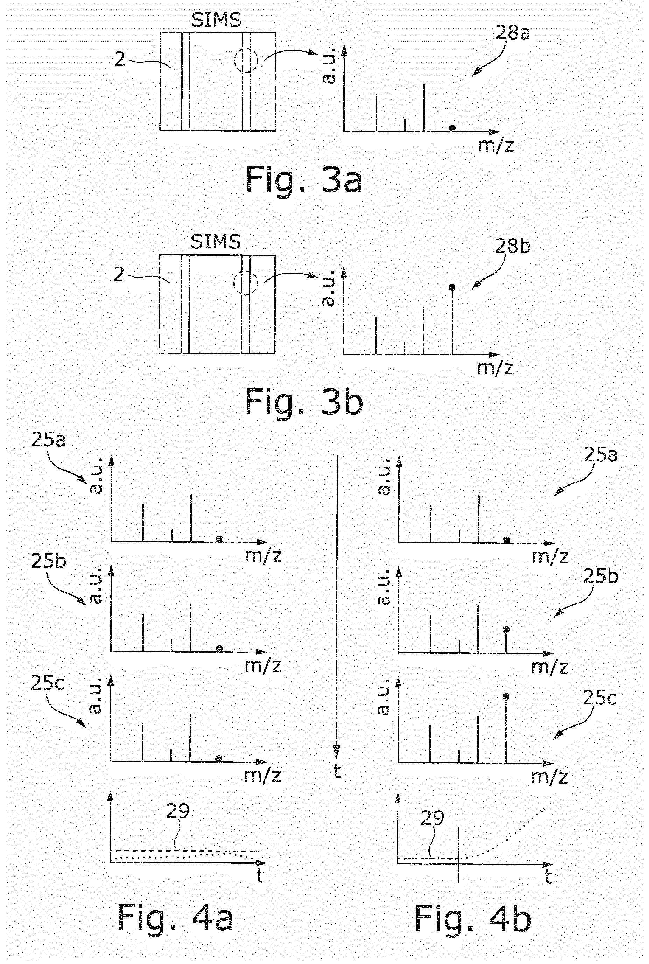

**Fig. 3a,b** show a wafer 2 that has been processed by atomic layer deposition in the process chamber 5 of the apparatus 1 of Fig. 1. The processed wafer 2 is inspected by a post-process measuring method in the form of Secondary Ion Mass Spectrometry (SIMS). The SIMS itself could be based on any mass spectrometric method like (e.g. Time-Of-Flight (TOF), magnetic sector field, FT-ion trap or any other mass analysing method). The SIMS method provides metrology data 28a, 28b in the form of spatially resolved mass spectra of the surface of the wafer 2. A respective mass spectrum 28a, 28b of an (identical) portion of the surface of the wafer 2 is also represented in Fig. 3a,b. The mass spectrum 28a of the wafer 2 shown in Fig. 3a differs from the mass spectrum 28b of the wafer 2 shown in Fig. 3b in the concentration of one constituent having a specific mass-to-charge ratio (m/z) (ion-peak value represented by a dot in Fig. 3a,b). As can be gathered from Fig. 3a,b, the concentration of the constituent on the wafer 2 of Fig. 3a is low, whereas the concentration of the constituent on the wafer 2 of Fig. 3b is considerable. However, in the present example, the concentration of the specific constituent on the wafer 2 should be as low as possible. In other words, the wafer 2 shown in Fig. 3a is considered as acceptable, whereas the wafer 2 shown in Fig. 3b is considered not acceptable and is therefore rejected.

Based on the metrology data 28a, 28b obtained by the SIMS method, an upcoming ALD process performed in the process chamber 5 may be evaluated in real-time as will be described below with reference to **Fig. 4a,b.** Both Fig. 4a and Fig. 4b show a time series of three exemplary mass spectra 25a-c obtained by the mass spectrometric real-time measurement described above. In the present example, each of the mass spectra 25a-c is compared / calibrated with metrology data 28a, 28b in the form of the mass spectra of the SIMS method shown in Fig. 3a,b that is indicative of an acceptable, resp., of an unacceptable outcome of the monitored ALD process. In particular, the mass spectrum 28a of Fig. 3a that is indicative of an acceptable outcome of the ALD process may serve as a "fingerprint spectrum" for calibrating the monitored process.

In the example shown in Fig. 4a, the real-time mass spectra 25a-c correspond almost exactly to the "fingerprint spectrum" shown in Fig. 3a, so that the result of the real-time evaluation of the monitored ALD process is that the monitored process is acceptable. In contrast thereto, in the example shown in Fig. 4b, the concentration of the specific constituent shown in Fig. 3a,b steadily increases until it reaches an unacceptable level, as can be gathered by comparing the third real-time mass spectrum 25c with the SIMS mass spectrum 28b shown in Fig. 3b.

As the mass spectra 25a-c of Fig. 4b are obtained in real-time, real-time decision making can be performed for deciding how to further proceed with the process shown in Fig. 4b: For instance, it may be decided to stop the monitored process when the concentration of the specific constituent reaches the corresponding level shown in the third mass spectrum 25c. As, in the present example, the time evolution of the mass spectra 25a-c is also evaluated, the increase of the concentration of the specific constituent is detected and at least one process parameter of the monitored process is adjusted by the control unit 15 in real-time in order to reduce the concentration of that specific constituent in the process chamber 5. Of course, if the reduction of the concentration of that specific constituent in the process chamber 5 is not successful, so that the concentration increases further, it may still be necessary to decide to stop the process, which may be done in the control unit 15 or manually by an operator.

Based on the evaluation described above, in particular based on the evaluation of the time evolution of mass spectra 25a-c of the monitored process, it is possible to predict an outcome of the monitored process and/or an outcome of at least one post-process metrology method used for evaluating the monitored process. For instance, the concentration of the specific constituent (e.g. a contaminant) that is observed in the respective real-time mass spectra 25a-c may be added up to provide an indication of the concentration of that constituent in the processed wafer 2, resp., in the coating 14 after the ALD process. In this way, it is also possible to predict the outcome of the post-process SIMS measuring method described above, or of other post-process measuring methods.

The diagrams at the bottom of Fig. 4a,b show a time evolution of the concentration of the specific constituent of the gas mixture 4 represented by a dot in the mass spectra 25a-c. Each point indicated in the diagram corresponds to a concentration (ion-peak value) of that specific constituent measured in real-time. In the process that is monitored in Fig. 4a, the concentration of the specific constituent is below a limit value 29 of a process window of the monitored ALD process. In contrast thereto, in the monitored process shown in Fig. 4b, the concentration of the specific constituent increases until it exceeds the limit value 29. As in the case described above the control unit 15 or an operator may decide to stop the ALD process immediately once the limit value is exceeded. The limit value 29 itself may be determined based on metrology data 28a,b obtained e.g. by the SIMS method indicated above. When using the limit value 29 for evaluating the process, the comparison / calibration with the mass spectra 28a,b shown in Fig. 3a,b may be dispensed with. It will be understood that in addition or alternatively to the SIMS method, other post-process metrology methods may be used as well for performing the calibration / comparison / correlation, e.g. X-Ray-diffraction, scanning electron microscopy, X-ray photoelectron spectroscopy, ellipsometry, etc. It will be understood that the comparison of the real-time mass spectrometric data in the form of the concentration (ion-peak value) of one constituent of the gas mixture to a limit value 29 of that constituent constitutes a simple example of such a comparison, and that the limit value 29 may be a more complex function of ion-peak values of the constituents of the gas mixture. In particular, the comparison may include a logical combination of two or more limit values, e.g. an AND or an OR combination of limit values.

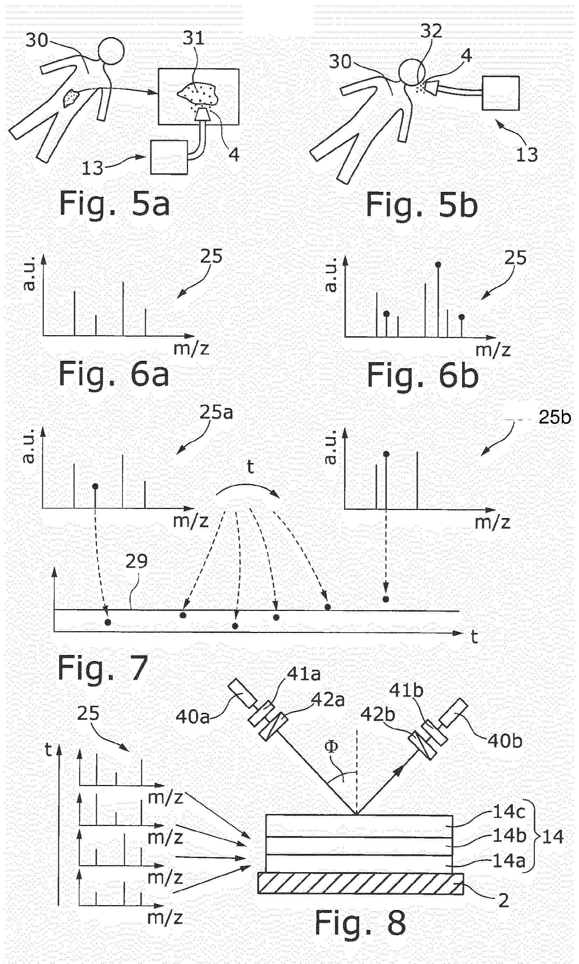

**Fig. 5a,b** show the mass spectrometer 13 of Fig. 2 that is used for monitoring outgassing from a human tissue 31 that is taken from a living patient 30, resp., from the mouth 32 of a patient 30. In both cases, the gas mixture 4 is typically provided to the mass spectrometer 13 from the ambient air a few centimetres above the tissue 31, resp., above the mouth/nose of the patient 30.

**Fig. 6a,b** show real-time mass spectra 25 of human tissue 31 which are determined using the mass spectrometer 13 in the way described above. Fig. 6a shows a mass spectrum of normal tissue and Fig. 6b shows a mass spectrum of pathological tissue. In the mass spectrum 25 of Fig. 6b, three specific constituents of the gas mixture 4 are considered as pathological (indicated with dots in Fig. 6b). The fact that these three constituents are pathological is determined by post-process metrology, e.g. histology, pathology or proton-induced X-ray emission spectroscopy, of human tissue that has been excised from previous patients. Thus, to evaluate the outgassing, resp., to determine if the tissue is pathological or not, the mass spectra 25 obtained by the real-time measurement method may be compared with metrology data obtained by these post-process metrology methods, or may be compared with limit values of the concentration of the three pathological constituents, the limit values having been identified based on metrology data obtained by the post-process metrology method(s) indicated above. Based on the mass spectra 25, a doctor may decide in real-time whether or not the tissue is pathological and has to be excised from the patient 30. In a similar way, based on the mass spectra of the gas mixture 4 of the expiration of the patient 30, a doctor can make a real-time diagnosis whether or not the patient 30 has a disease, and possibly may also provide a diagnosis of the type of disease.

**Fig. 7** shows two mass spectra 25a, 25b of a series of mass spectra 25a-f obtained in a real-time mass spectrometric measurement of a gas mixture 4 that is emitted from an emission source such as a motor or the like. In a similar way as explained with reference to Fig. 4a,b, the time evolution of a specific constituent of the gas mixture 4 is compared with a limit value 29. Contrary to the example of Fig. 4a,b, the limit value 29 is not derived from post-process metrology, but is determined by law, e.g. constitutes a legal limit of the concentration of a specific constituent such as $CO_2$ gas that is allowed to be emitted by the emission source. Also in this case of environmental monitoring, it is possible to perform real-time decisions based on the evaluation of the concentration of the specific constituent, e.g. changing at least one process parameter when the concentration of the process-critical constituent of the gas mixture 4 exceeds the limit value 29 in order to reduce the concentration of that constituent.

**Fig. 8** shows three layers 14a-c that have been deposited on the wafer 2 by atomic layer deposition in the apparatus 1 of Fig. 1. As can be gathered from Fig. 8, real-time mass spectrometric data in the form of mass spectra 25 has been obtained by the mass spectrometric real-time measurement described above during the deposition of each of the three layers 14a-c. Moreover, ellipsometry is performed on the coating 14 comprising the three layers 14a-c as a post-process metrology method. In ellipsometry, the wafer 2 is inspected by an ellipsometer that comprises a light source 40a for directing light towards the coating 14, a first polarizer 42a for polarizing the light incident on the coating 14, a second polarizer for polarizing the light being reflected from the coating 14, and a detector 40b for detecting the light reflected from the coating 14. In the ellipsometer of Fig. 8, two optional compensators 42a,b are also shown.

The ellipsometry measurement serves to determine the change in polarization of the light reflected (or transmitted) from a probe, in the present case from the coating 14 of the wafer 2. The change in polarization depends in particular on the angle of incidence Φ of the light on the coating 14 that is typically varied during the ellipsometry measurement. In the present case, correlating the metrology data of the post-process ellipsometry measurement allows to determine the thicknesses thi, $th_2$, $th_3$ of the three layers 14a-c of the coating 14 even though the constituents vary during the deposition process, so that the equation for the overall thickness th of the coating 14 can be expressed as follows (i = 1 to 3):

$$th = \Sigma \, \alpha_i \, \rho_i \, R_i \, T_i,$$

where i indicates that each constituent group, i.e. each layer (i = 1, 2, 3) has its own proportionality constant $\alpha_i$, density $\rho_i$, rate $R_i$ and deposition time $T_i$. In the above equation, the deposition time $T_i$ for each layer 14a-c during the process is known, the proportionality constant $\alpha_i$ is a fitting parameter and the unknown parameters in the form of the density $\rho_i$ and the rate $R_i$ have to be determined.

Based on a model which correlates the calibrated mass-spectrometric data 25 obtained during the ALD process with metrology data obtained by the ellipsometry method indicated above, the unknown parameters density $\rho_i$ and rate $R_i$ of the individual layers 14a-c may be determined and thus the thickness $th_i$ of each individual layer 14a-c that has been deposited on the wafer 2 can be determined. The thicknesses $th_1$, $th_2$, $th_3$ of the layers 14a-c that are determined in this way may be used to perform a post-process evaluation of the monitored process, i.e. of the outcome of the monitored process, as the thickness thi, $th_2$, $th_3$ of each deposited layer 14a-c should lie within a pre-defined process window (i.e. within a pre-defined thickness interval). It will be understood that the metrology data about the thickness $th_1$, $th_2$, $th_3$ of each deposited layer 14a-c obtained in the way described above may also be used for the real-time evaluation of upcoming processes.

In addition to the real-time mass-spectrometric data obtained in the way described above, further real-time data indicative of the monitored process may be obtained by performing at least one further real-time measurement method, and the monitored process may be evaluated by correlating and/or calibrating the further real-time data with metrology data determined by at least one post-process metrology method for evaluating a previous process and/or by comparing the further real-time data with at least one limit value, preferably with a limit value of a process window of the monitored process. The limit value itself may represent a more or less complex function of ion-peak values. The further real-time data may be used together with the real-time mass-spectrometric data to evaluate the monitored process in real-time. The further real-time measurement method may be selected e.g. from the group consisting of: optical emission spectroscopy, optical absorption spectroscopy, comparing the further real-time data with at least one limit value, preferably with a limit value of a process window of the monitored process. The limit value itself may represent a more or less complex function of ion-peak values. The further real-time data may be used together with the real-time mass-spectrometric data to evaluate the monitored process in real-time. The further real-time measurement method may be selected e.g. from the group consisting of: optical emission spectroscopy, optical absorption spectroscopy, reflectometry, pyrometry, Raman scattering, scatterometry, in-situ X-Ray diffractometry, and quadrupole rest gas analyzation.

In summary, the real-time monitoring described hereinabove allows to improve real-time decision making by combining real-time monitoring with metrology data of off-line post-process measurements. In contrast thereto, in semiconductor manufacturing and chemical gas production, very often only post process measurements such as X-Ray diffraction, SIMS, SEM, XPS, ellipsometry or scatterometry have been used for the determination of failure or success of the monitored process. In the case of surgery, the common approach has been ex-situ off-line histology without any real-time monitoring and decision making, i.e. a correlation between real-time monitoring and histology in order to improve real-time decision making did not exist. The invention is defined by the claims.

## Claims

1. A method for real-time monitoring of a surface processing of an object, in particular for a deposition process of a plurality of layers on a wafer (2), comprising:
   performing a mass spectrometric real-time measurement of a gas mixture (4) generated in the monitored process to determine real-time mass spectrometric data (25, 25a-c, 25a-f) indicative of the monitored process, evaluating the monitored process by correlating and/or calibrating the real-time mass spectrometric data (25, 25a-c, 25a-f) with metrology data (26a, 26b) determined by at least one post-process metrology method for evaluating a previous process.

2. The method according to claim 1, further comprising: based on the evaluation of the monitored process, performing a decision to either proceed with or to stop the monitored process.

3. The method according to claim 1 or 2, further comprising: based on the evaluation of the monitored process, changing at least one process parameter of the monitored process in real-time.

4. The method according to anyone of the preceding claims, further comprising: based on the evaluation of the monitored process, predicting an outcome of the monitored process and/or an outcome of at least one post-process metrology method used for evaluating the monitored process.

5. The method according to anyone of the preceding claims, wherein the at least one post-process metrology method for evaluating the previous process is a post-process metrology method for inspecting an object (2) that is processed in the previous process.

6. The method according to anyone of the preceding claims, wherein the post-process metrology method is selected from the group consisting of: X-Ray-diffraction, secondary ion mass spectrometry, scanning electron microscopy, X-ray photoelectron spectroscopy, and ellipsometry.

7. The method according to anyone of the preceding claims, wherein performing the mass spectrometric real-time measurement of the gas mixture (4) comprises storing and analysing ions (4a, 4b) of at least part of the gas mixture (4) in an ion trap (18) of an FT-Ion-Trap-Mass Spectrometer (13).

8. The method according to claim 7, further comprising: selectively exciting at least part of the ions (4a, 4b) in the ion trap (18) in dependence of a mass-to-charge ratio (m/z) of the ions (4a, 4b), in particular using a SWIFT excitation.

9. The method according to anyone of the preceding claims, further comprising: obtaining further real-time data indicative of the monitored process by performing at least one further real-time measurement method, and evaluating the monitored process by correlating and/or calibrating the further real-time data with metrology data determined by at least one post-process metrology method for evaluating a previous process and/or by comparing the further real-time data with at least one limit value, preferably with a limit value of a process window of the monitored process.

10. The method according to claim 9, wherein the further real-time
    measurement method is selected from the group consisting of: optical emission spectroscopy, optical absorption spectroscopy, reflectometry, pyrometry, Raman scattering, scatterometry, in-situ X-Ray diffractometry, and quadrupole rest gas analyzation.

11. The method according to anyone of the preceding claims, further
    comprising: evaluating the monitored process by comparing the real-time mass spectrometric data (25, 25a-c, 25a-f) with at least one limit value (29), preferably with a limit value (29) of a process window of the monitored process.

12. A mass spectrometer (13) for real-time monitoring of a surface processing of an object, in particular for a deposition process of a plurality of layers on a wafer (2), comprising:

an ionization unit (26) for generating ions (4a, 4b) of at least part of a gas mixture (4) generated during the monitored process,
an FT ion trap (18) for storing the ions (4a, 4b) of the gas mixture (4),
an excitation unit (22a, 22b) for exciting at least part of the ions (4a, 4b) stored in the FT ion trap (18),
a detector (24) for determining, based on the excited ions (4a, 4b), real-time mass spectrometric data (25) of the gas mixture (5) indicative for the monitored process, and
an evaluation unit (27) adapted to evaluate the monitored process, wherein the evaluation unit is adapted to correlate and/or calibrate the real-time mass spectrometric data (25) with metrology data (26a, 26b) determined by at least one post-process metrology method for evaluating a previous process.

13. The mass spectrometer according to claim 12, wherein the evaluation unit (27) is adapted to predict, based on the evaluated monitored process, an outcome of the monitored process and/or an outcome of a post-process metrology method used for evaluating the monitored process.

14. The mass spectrometer according to anyone of claims 12 or 13, wherein the at least one post-process metrology method for evaluating the previous process is a post-process metrology method for inspecting an object (2) that is processed in the previous process.

15. The mass spectrometer according to anyone of claims 12 to 14, wherein the evaluation unit (27) is further adapted to evaluate the monitored process and to compare the real-time mass spectrometric data (25) with at least one limit value (29), preferably with a limit value (29) of a process window of the monitored process.

**Patentansprüche**

1. Verfahren zur Echtzeitüberwachung einer Oberflächenbearbeitung eines Objekts, insbesondere eines Auftragsprozesses einer Mehrzahl von Schichten auf einem Plättchen (2), das umfasst:
Durchführen einer massenspektrometrischen Echtzeitmessung eines Gasgemischs (4), das in dem überwachten Prozess erzeugt wird, um massenspektrometrische Echtzeitdaten (25, 25a-c, 25a-f) zu bestimmen, die für den überwachten Prozess bezeichnend sind, Auswerten des überwachten Prozesses durch Korrelieren und/oder Kalibrieren der massenspektrometrischen Echtzeitdaten (25, 25a-c, 25a-f) mit metrologischen Daten (26a, 26b), die durch mindestens ein metrologisches Verfahren nach dem Prozess zur Auswertung eines vorherigen Prozesses bestimmt wurden.

2. Verfahren nach Anspruch 1, das weiter aufweist: Durchführung einer Entscheidung auf Basis der Auswertung des überwachten Prozesses, entweder den überwachten Prozess fortzuführen oder ihn anzuhalten.

3. Verfahren nach Anspruch 1 oder 2, das weiter umfasst: basierend auf der Auswertung des überwachten Prozesses, Verändern mindestens eines Prozessparameters des überwachten Prozesses in Echtzeit.

4. Verfahren nach irgendeinem der vorhergehenden Ansprüche, das weiter umfasst:
basierend auf der Auswertung des überwachten Prozesses, Vorhersagen eines Ausgangs des überwachten Prozesses und/oder eines Ausgangs mindestens eines metrologischen Verfahrens nach dem Prozess, das zur Auswertung des überwachten Prozesses benutzt wird.

5. Verfahren nach irgendeinem der vorhergehenden Ansprüche, wobei das mindestens eine metrologische Verfahren nach dem Prozess zum Auswerten des vorherigen Prozesses ein metrologisches Verfahren nach dem Prozess zum Inspizieren eines Objekts (2) ist, das in dem vorherigen Verfahren bearbeitet wurde.

6. Verfahren nach irgendeinem der vorhergehenden Ansprüche, wobei das metrologische Verfahren nach dem Prozess aus der Gruppe ausgewählt ist, die besteht aus:
Röntgenbeugung, sekundäre Ionen-Massenspektrometrie, Abtastende Elektronenmikroskopie, Röntgen-Fotoelektronen-Spektroskopie, und Elypsometrie.

7. Verfahren nach irgendeinem der vorhergehenden Ansprüche, wobei die massenspektrometrische Echtzeitmessung des Gasgemischs (4) das Speichern und Analysieren von Ionen (4a, 4b) von mindestens einem Teil des Gasgemischs (4) in einer Ionenfalle (18) eines FT-Ionenfallen-Massenspektrometers (13) erfolgt.

8. Verfahren nach Anspruch 7, das weiter umfasst: selektives Erregen mindestens eines Teils der Ionen (4a, 4b) in der Ionenfalle (18) in Abhängigkeit von einem Massen-Ladungs-Verhältnis (m/z) der Ionen (4a, 4b), insbesondere unter Anwendung einer SWIFT-Erregung.

9. Verfahren nach irgendeinem der vorhergehenden Ansprüche, das weiter umfasst:
Erhalten weiterer Echtzeitdaten, die für den überwachten Prozess bezeichnend sind, durch Durchführen mindestens eines weiteren Echtzeitmessverfahrens und Auswerten des überwachten Prozesses durch Korrelieren und/oder Kalibrieren der weiteren Echtzeitdaten mit metrologischen Daten, die durch mindestens ein metrologisches Verfahren nach dem Prozess zum Auswerten eines vorherigen Prozesses und/oder durch Vergleichen der weiteren Echtzeitdaten mit mindestens einem Grenzwert, vorzugsweise mit einem Grenzwert eines Prozessfensters des überwachten Prozesses, bestimmt wurden.

10. Verfahren nach Anspruch 9, wobei das weitere Echtzeitmessverfahren aus der Gruppe ausgewählt ist, die besteht aus: optische Emissionsspektroskopie, optische Absorptionsspektroskopie, Reflektometrie, Pyrometrie, Raman-Streuung, Streuungsmessung, vor-Ort-Röntgen-Diffraktometrie, und Quadropol-Restgasanalysierung.

11. Verfahren nach irgendeinem der vorhergehenden Ansprüche, das weiter umfasst:
Auswerten des überwachten Prozesses durch Vergleichen der massenspektrometrischen Echtzeitdaten (25, 25a-c, 25a-f) mit mindestens einem Grenzwert (29), vorzugsweise mit einem Grenzwert (29) eines Prozessfensters des überwachten Prozesses.

12. Massenspektrometer (13) zur Echtzeitüberwachung einer Oberflächenbearbeitung eines Objekts, insbesondere eines Auftragsprozesses für eine Mehrzahl von Schichten auf einem Plättchen (2), mit:

einer Ionisierungseinheit (26) zum Erzeugen von Ionen (4a, 4b) von mindestens einem Teil eines Gasgemischs (4), das während des überwachten Prozesses erzeugt wird, einer FT-Ionenfalle (18) zum Speichern der Ionen (4a, 4b) des Gasgemischs (4),
eine Erregungseinheit (22a, 22b) zum Erregen mindestens eines Teils der Ionen (4a, 4b), die in der FT-Ionenfalle (18) gespeichert sind,
einem Detektor (24) zum Bestimmen, basierend auf den erregten Ionen (4a, 4b), von massenspektrometrischen Echtzeitdaten (25) des Gasgemischs (5), die für den überwachten Prozess bezeichnend sind, und
einer Auswerteeinheit (27), die zum Auswerten des überwachten Prozesses ausgebildet ist, wobei die Auswerteeinheit zum Korrelieren und/oder Kalibrieren der massenspektrometrischen Echtzeitdaten (25) mit metrologischen Daten (26a, 26b) ausgebildet ist, die durch mindestens ein metrologisches Verfahren nach dem Prozess zum Auswerten eines vorherigen Prozesses bestimmt wurden.

13. Massenspektrometer nach Anspruch 12, wobei die Auswerteeinheit (27) dafür ausgebildet ist, basierend auf dem ausgewerteten überwachten Prozess, einen Ausgang des überwachten Prozesses und/oder einen Ausgang eines metrologischen Verfahrens nach dem Prozess, das zur Auswertung des überwachten Prozesses benutzt wird, vorherzusagen.

14. Massenspektrometer nach einem der Ansprüche 12 oder 13, wobei das mindestens eine metrologische Verfahren nach dem Prozess zum Auswerten des vorherigen Prozesses ein metrologisches Verfahren nach dem Prozess zum Inspizieren eines Objekts (2) ist, das in dem vorhergehenden Prozess bearbeitet wurde.

15. Massenspektrometer nach einem der Ansprüche 12 bis 14, wobei die Auswerteeinheit (27) weiter dafür ausgebildet ist, den überwachten Prozess auszuwerten und die massenspektrometrischen Echtzeitdaten (25) mit mindestens einem Grenzwert (29), vorzugsweise mit einem Grenzwert (29) eines Prozessfensters des überwachten Prozesses, zu vergleichen.

**Revendications**

1. Procédé de surveillance en temps réel d'un traitement de surface d'un objet, en particulier pour un processus de dépôt d'une pluralité de couches sur une tranche (2), comprenant :

la réalisation d'une mesure en temps réel par spectrométrie de masse d'un mélange gazeux (4) généré dans le processus surveillé pour déterminer des données de spectrométrie de masse en temps réel (25, 25a-c, 25a-f) indicatives du processus surveillé,
l'évaluation du processus surveillé par la corrélation et/ou l'étalonnage des données de spectrométrie de masse en temps réel (25, 25a-c, 25a-f) avec des données de métrologie (26a, 26b) déterminées par au moins un procédé de métrologie post-processus pour évaluer un processus précédent.

2. Procédé selon la revendication 1, comprenant en outre : sur la base de l'évaluation du processus surveillé, la prise d'une décision soit de poursuivre soit d'interrompre le processus surveillé.

3. Procédé selon la revendication 1 ou 2, comprenant en outre : sur la base de l'évaluation du processus surveillé, le changement d'au moins un paramètre de processus du processus surveillé en temps réel.

4. Procédé selon l'une quelconque des revendications précédentes, comprenant en outre : sur la base de l'évaluation du processus surveillé, la prédiction d'une issue du processus surveillé et/ou d'une issue d'au moins un procédé de métrologie post-processus utilisé pour évaluer le processus surveillé.

5. Procédé selon l'une quelconque des revendications précédentes, dans lequel l'au moins un procédé de métrologie post-processus pour évaluer le processus précédent est un procédé de métrologie post-processus pour inspecter un objet (2) qui est traité dans le processus précédent.

6. Procédé selon l'une quelconque des revendications précédentes, dans lequel le procédé de métrologie post-processus est sélectionné parmi le groupe constitué de : la diffraction des rayons X, la spectrométrie de masse des ions secondaires, la microscopie électronique à balayage, la spectroscopie photoélectronique par rayons X et l'ellipsométrie.

7. Procédé selon l'une quelconque des revendications précédentes, dans lequel la réalisation de la mesure en temps réel par spectrométrie de masse du mélange gazeux (4) comprend le stockage et l'analyse d'ions (4a, 4b) d'au moins une partie du mélange gazeux (4) dans un piège à ions (18) d'un spectromètre de masse à piège à ions à transformée de Fourier, FT (13).

8. Procédé selon la revendication 7, comprenant en outre : l'excitation sélective d'au moins une partie des ions (4a, 4b) dans le piège à ions (18) en fonction d'un rapport masse sur charge (m/z) des ions (4a, 4b), en particulier à l'aide d'une excitation par transformée de Fourier inverse de forme d'onde stockée, SWIFT.

9. Procédé selon l'une quelconque des revendications précédentes, comprenant en outre : l'obtention de données en temps réel supplémentaires indicatives du processus surveillé par la réalisation d'au moins un procédé de mesure en temps réel supplémentaire, et l'évaluation du processus surveillé par la corrélation et/ou l'étalonnage des données en temps réel supplémentaires avec des données de métrologie déterminées par au moins un procédé de métrologie post-processus pour évaluer un processus précédent et/ou par la comparaison des données en temps réel supplémentaires avec au moins une valeur limite, de préférence avec une valeur limite d'une fenêtre de processus du processus surveillé.

10. Procédé selon la revendication 9, dans lequel le procédé de mesure en temps réel supplémentaire est sélectionné parmi le groupe constitué de : la spectroscopie d'émission optique, la spectroscopie d'absorption optique, la réflectométrie, la pyrométrie, la diffusion Raman, la diffusiométrie, la diffractométrie in situ par rayons X et l'analyse quadripolaire de gaz résiduels.

11. Procédé selon l'une quelconque des revendications précédentes, comprenant en outre : l'évaluation du processus surveillé par la comparaison des données de spectrométrie de masse en temps réel (25, 25a-c, 25a-f) avec au moins une valeur limite (29), de préférence avec une valeur limite (29) d'une fenêtre de processus du processus surveillé.

12. Spectromètre de masse (13) pour la surveillance en temps réel d'un traitement de surface d'un objet, en particulier pour un processus de dépôt d'une pluralité de couches sur une tranche (2), comprenant :

une unité d'ionisation (26) pour générer des ions (4a, 4b) d'au moins une partie d'un mélange gazeux (4) généré pendant le processus surveillé, un piège à ions à FT (18) pour stocker les ions (4a, 4b) du mélange gazeux (4), une unité d'excitation (22a, 22b) pour exciter au moins une partie des ions (4a, 4b) stockés dans le piège à ions à FT (18), un détecteur (24) pour déterminer, sur la base des ions excités (4a, 4b), des données de spectrométrie de masse en temps réel (25) du mélange gazeux (5) indicatives du processus surveillé, et une unité d'évaluation (27) adaptée pour évaluer le processus surveillé, dans lequel l'unité d'évaluation est adaptée pour corréler et/ou étalonner les données de spectrométrie de masse en temps réel (25) avec des données de métrologie (26a, 26b) déterminées par au moins un procédé de métrologie post-processus pour évaluer un processus précédent.

13. Spectromètre de masse selon la revendication 12, dans lequel l'unité d'évaluation (27) est adaptée pour prédire, sur la base du processus surveillé évalué, une issue du processus surveillé et/ou une issue d'un procédé de métrologie post-processus utilisé pour évaluer le processus surveillé.

14. Spectromètre de masse selon l'une quelconque des revendications 12 ou 13, dans lequel l'au moins un procédé de métrologie post-processus pour évaluer le processus précédent est un procédé de métrologie post-processus pour inspecter un objet (2) qui est traité dans le processus précédent.

**15.** Spectromètre de masse selon l'une quelconque des revendications 12 à 14, dans lequel l'unité d'évaluation (27) est en outre adaptée pour évaluer le processus surveillé et pour comparer les données de spectrométrie de masse en temps réel (25) avec au moins une valeur limite (29), de préférence avec une valeur limite (29) d'une fenêtre de processus du processus surveillé.

Fig. 1

Fig. 2

Fig. 3a

Fig. 3b

Fig. 4a

Fig. 4b

Fig. 5a

Fig. 5b

Fig. 6a

Fig. 6b

Fig. 7

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2013104583 A2
- WO 2015003819 A1
- WO 2016177503 A1
- US 2007224840 A1

### Non-patent literature cited in the description

- **R.G. COSWAY et al.** A Novel Technique for Epitaxy Tool-to-Tool and Chamber Matching and Optimization. *27th Annual SEMI Advanced Semiconductor Manufacturing Conference (ASMC) 2016, IEEE proceedings,* 2016, 429-434
- **D. CRAUDER et al.** Reducing Metrology Mean-Time-To-Detect by Utilizing Product Data. *ASMC 2016, IEEE proceedings,* 2016, 423-428
- **CHUNG HIN YU et al.** Very sensitive real-time inline process mass spectrometer based on FFT Ion Trap technique. *27th annual SEMI Advanced Semiconductor manufacturing Conference(ASMC), 2016, IEEE Proceedings,* 2016, 263-266
- **NITI GARG et al.** Yield Improvement and Queue Time Relaxation at Contact Process. *ASMC 2016, IEEE proceedings,* 2016, 344-349